# EUROPEAN PATENT APPLICATION

(11) **EP 1 536 460 A1**
(43) Date of publication of application: **01.06.2005**
(21) Application number: 03733530.4
(22) Date of filing: 20.06.2003
(51) Int. Cl.: H01L 21/304, H01L 21/306

(54) **SUBSTRATE PROCESSING DEVICE AND SUBSTRATE PROCESSING METHOD**

(30) Priority: 21.06.2002 JP 2002181151
(71) Applicant: Sipec Corporation, Bunkyo-ku, Tokyo 112-0012 (JP)
(72) Inventor: MATSUZAWA, Minoru c/o SIPEC CORPORATION, 3-11-6, Ohtsuka Bunkyo-ku, Tokyo 112-001 (JP); NAGASAKA, Michio c/o SIPEC CORPORATION, 3-11-6, Ohtsuka Bunkyo-ku, Tokyo 112-001 (JP)
(74) Representative: VOSSIUS & PARTNER
(86) International application number: PCT/JP2003/007849
(87) International publication number: WO 2004/001828

(57) **Abstract**

In a substrate treatment apparatus, a substrate to be treated (11) held on a substrate chuck section (13) is spun, and a plurality of treatment solutions are supplied onto the substrate to be treated (11). The apparatus has a plurality of collection tanks (16 to 19) provided to collect by kind the treatment solutions, scattered by a spin unit (15) from the substrate to be treated (11). To collect the treatment solution by one of the collection tanks, a lifting mechanism (28) is driven so that the treatment solution is collected with an inlet of only the collection tank opened, thereby preventing the treatment solution to be collected from mixing into the other collection tanks.

## Description

### Technical Field

The present invention relates to a substrate treatment apparatus and a treatment method thereof and, more specifically, to those preferably used to separately collect various treatment solutions which have treated a substrate.

### Background Art

Conventionally, in various manufacturing processes of forming semiconductor devices and the like on a substrate, a single-wafer type substrate treatment apparatus which performs chemicals treatments such as wet etching, wet cleaning, and so on is used. This substrate treatment apparatus supplies various chemicals to a substrate fixed in position while spinning the substrate to thereby perform various treatments on the substrate. The chemical which has treated the substrate is scattered from the substrate by centrifugal force of the spin and is collected in a collection tank provided beside the substrate and then drained. In this event, the chemical scattered from the substrate mixes with ambient air into a mist form or a gas form and collected in the collection tank.

In a conventional substrate treatment, when collecting the chemicals which have treated the substrate, to prevent production of salt due to chemical reaction by mixing of an acid chemical with an alkaline chemical to cause particles, a treatment using the acid chemical and a treatment using the alkaline chemical are performed by different substrate treatment apparatuses.

Here, the above-described method for collecting chemicals will be described, taking Japanese Patent Application Laid-open No. Hei 5-283395 as an example of the substrate treatment apparatus in the conventional art.

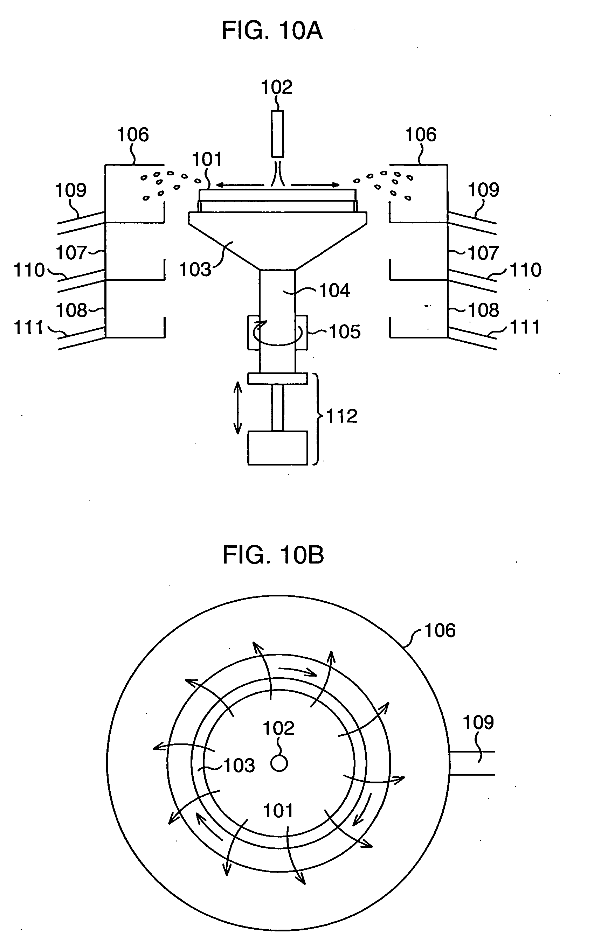

Fig. 10A and Fig. 10B are schematic views of a substrate treatment apparatus of the conventional example, its cross-sectional view being shown in Fig. 10A and its top view being shown in Fig. 10B.

As shown in Fig. 10A and Fig. 10B, a numeral 101 denotes a substrate being a treatment object, a numeral 102 denotes a chemical supply nozzle for supplying various chemicals onto the substrate 101, a numeral 103 denotes a substrate chuck section for holding the substrate thereon, a numeral 104 denotes a shaft connected to the substrate chuck section 103, a numeral 105 denotes a motor for spinning the substrate 101 held on the substrate chuck section 103 in the axial direction of the shaft 104, numerals 106 to 108 denote collection pots provided to collect by kind the various chemicals, numerals 109 to 111 denote drain mechanisms provided in the respective collection pots 106 to 108, and a numeral 112 denotes a lifting device for moving the level of the substrate chuck section 103 in the vertical direction.

In the substrate treatment apparatus shown in the conventional example, the substrate chuck section 103 holds the substrate 101, a chemical is supplied from the chemical supply nozzle 102 onto the substrate 101 while the substrate 101 is being spun in the axial direction of the shaft 104 by driving the motor 105, thereby treating the substrate 101. The chemical scattered from the substrate 101 due to the spin of the motor 105 is collected in the collection pot 106. Further, the collected chemical is drained through the drain mechanism 109.

Subsequently, the lifting mechanism 112 is driven to move the position of the substrate 101 to the position of an inlet of the collection pot 107. Then, another chemical is supplied from the chemical nozzle 102 onto the substrate 101 while the substrate is being spun by driving the motor 105 to thereby treat the substrate 101, and the treated chemical is collected in the collection pot 107. Subsequently, the lifting mechanism 112 is driven to move the position of the substrate 101 to the position of an inlet of the collection pot 108, still another chemical treats the substrate 101 in a similar manner to that previously described, and the treated chemical is collected in the collection pot 108. The various chemicals, which have treated the substrate 101 and are collected in the collection pots 106 to 108, mix with ambient air and are collected in a mist form or a gas form. In the above manner, the plurality of chemicals which have treated the substrate 101 are separately collected.

In the above-described conventional substrate treatment apparatus, however, the chemical is collected with openings of the other collection pots opened, and therefore the chemical in the mist form or the gas form after the treatment of the substrate might mix into the other collection ports. This will cause occurrence of the above-described particles when the treatment using an acid chemical and the treatment using an alkaline chemical are performed, bringing about a particularly significant problem. To prevent such mixing of the chemical, it is necessary, for example, to use substrate treatment apparatuses in combination when performing the treatment using an acid chemical and the treatment using an alkaline chemical. This brings about another problem that treatments performed by the plurality of substrate treatment apparatuses will cause complexity in process steps.

The present invention has been developed in consideration of the above-described problems, and its object is to provide a reliable substrate treatment apparatus and substrate treatment method which ensure that when various different treatment solutions are used to perform various treatments on a substrate and then collected, mixing of the used treatment solutions in sequential process steps by the same apparatus configuration is prevented.

### Summary of the Invention

A substrate treatment apparatus of the present invention is characterized by including: a substrate holding unit for holding a substrate to be treated; a substrate spinning unit for spinning the substrate to be treated held on the substrate holding unit; a treatment solution supply unit for supplying a plurality of treatment solutions onto the substrate to be treated; and a treatment solution collection unit having a plurality of collection tanks placed in a manner to surround a periphery of the substrate to be treated held on the substrate holding unit, and provided to separately collect by kind the treatment solutions scattered by the substrate spinning unit from the substrate to be treated, wherein the treatment solution collection unit collects the treatment solution by one of the collection tanks with inlets of the other collection tanks closed.

Another aspect of the substrate treatment apparatus of the present invention is characterized in that the treatment solution collection unit has a plurality of fences and drives upwards a predetermined fence to thereby form a conduit of the collection tank which collects the treatment solution.

Further, still another aspect of the substrate treatment apparatus of the present invention is characterized in that a position of the substrate to be treated held on the substrate holding unit is located above positions of the fences which are not collecting the treatment solution.

Further, yet another aspect of the substrate treatment apparatus of the present invention is characterized in that the fences are arranged overlapping one another in order, from the fence closer to the substrate to be treated, in a manner to close the inlets of the collection tanks; and that the treatment solution collection unit performs collection in order, starting from the collection tank at a position farther from the substrate to be treated.

Further, still another aspect of the substrate treatment apparatus of the present invention is characterized in that the fence has a tip portion formed to be a reflective face that is curved to reflect the treatment solution scattered from the substrate to be treated to lead the treatment solution into the collection tank.

Further, still another aspect of the substrate treatment apparatus of the present invention is characterized in that exhaust units for separately exhausting internal gasses are provided for the collection tanks, respectively.

Further, still another aspect of the substrate treatment apparatus of the present invention is characterized in that drain units for draining the treatment solutions are provided for the collection tanks, respectively.

Further, still another aspect of the substrate treatment apparatus of the present invention is characterized by further including a cleaning unit for cleaning the inside of the collection tanks.

A substrate treatment method of the present invention is characterized by including the steps of: supplying a plurality of treatment solutions onto a held substrate to be treated while spinning the substrate; and when using a treatment solution collection unit having a plurality of collection tanks placed in a manner to surround a periphery of the substrate to be treated and provided to separately collect by kind the treatment solutions scattered from the substrate to be treated, to collect the treatment solution by one of the collection tanks, collecting the treatment solution only by the one of the collection tanks with inlets of the other tanks closed.

Further, another aspect of the substrate treatment method of the present invention is characterized in that the treatment solution collection unit has a plurality of fences and drives upwards a predetermined fence to thereby form a conduit of the collection tank which collects the treatment solution.

Further, still another aspect of the substrate treatment method of the present invention is characterized in that a position of the held substrate to be treated is located above positions of the fences which are not collecting the treatment solution.

Further, still another aspect of the substrate treatment method of the present invention is characterized in that the fences are arranged overlapping one another in order, from the fence closer to the substrate to be treated, in a manner to close the inlets of the collection tanks; and that the step of collecting the treatment solution performs collection in order, starting from the collection tank at a position farther from the substrate to be treated.

Further, still another aspect of the substrate treatment method of the present invention is characterized in that the fence has a tip portion formed to be a reflective face that is curved to reflect the treatment solution scattered from the substrate to be treated to lead the treatment solution into the collection tank.

Further, still another aspect of the substrate treatment method of the present invention is characterized by further including an exhausting step of separately exhausting internal gasses for the collection tanks, respectively.

Further, still another aspect of the substrate treatment method of the present invention is characterized by further including a drain step of draining the treatment solutions for the collection tanks, respectively.

Further, still another aspect of the substrate treatment method of the present invention is characterized by further including a cleaning step of cleaning the inside of the collection tanks.

### Brief Description of the Drawings

Fig. 1 is a schematic cross-sectional view showing an embodiment of a substrate treatment apparatus according to the present invention;
Fig. 2 is a schematic cross-sectional view of a lifting mechanism in the substrate treatment apparatus of the present embodiment;
Fig. 3 is a top cross-sectional view of the inside of the substrate treatment apparatus of the present embodiment;
Fig. 4 is a schematic cross-sectional view showing tip portions of fences forming collection tanks;
Fig. 5 is a schematic cross-sectional view showing the tip portions of the fences forming the collection tanks;
Fig. 6 is a schematic cross-sectional view showing a procedure of collecting chemicals by the substrate treatment apparatus of the present embodiment;
Fig. 7 is a schematic cross-sectional view showing the procedure of collecting chemicals by the substrate treatment apparatus of the present embodiment;
Fig. 8 is a schematic cross-sectional view showing the procedure of collecting chemicals by the substrate treatment apparatus of the present embodiment;
Fig. 9 is a schematic cross-sectional view showing the procedure of collecting chemicals by the substrate treatment apparatus of the present embodiment; and
Fig. 10A and Fig. 10B are schematic cross-sectional views of a substrate treatment apparatus of a conventional example.

### Detailed Description of the Preferred Embodiments

Hereinafter, concrete embodiments of a substrate treatment apparatus and a treatment method thereof according to the present invention will be described with reference to the accompanying drawings.

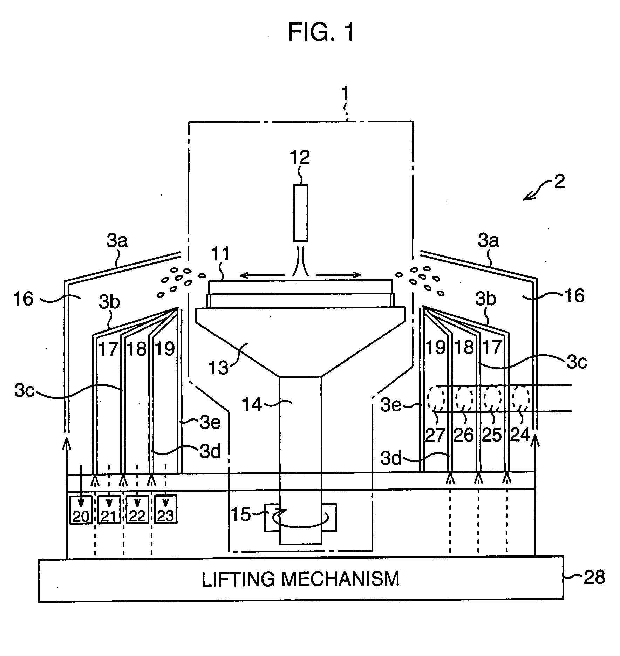

Fig. 1 is a schematic cross-sectional view showing an embodiment of a substrate treatment apparatus according to the present invention.

As shown in Fig. 1, this substrate treatment apparatus comprises a substrate treatment section 1 for allowing a substrate 11 being a treatment object to be placed therein and performing treatments using various treatment solutions (chemicals) on the surface of the substrate 11, and a chemical collection section 2 for selectively separately collecting the various chemicals used.

In the substrate treatment section 1, a numeral 12 denotes a chemical supply nozzle for supplying the various chemicals to the substrate 11, a numeral 13 denotes a substrate chuck section for holding the substrate 11, a numeral 14 denotes a shaft connected to the substrate chuck section 13, and a numeral 15 denotes a motor for spinning the substrate 11 held on the substrate chuck section 13 in the axial direction of the shaft 14.

In the chemical collection section 2, numerals 16 to 19 denote collection tanks partitioned by respective fences 3a to 3d to collect by kind the various chemicals, numerals 20 to 23 denote drain mechanisms provided for the collection tanks 16 to 19 respectively, numerals 24 to 27 denote exhaust mechanisms provided for the collection tanks 16 to 19 respectively, and a numeral 28 denotes a lifting mechanism for vertically driving the fences 3a to 3d forming the collection tanks 16 to 19 to form conduits of the respective collection tanks 16 to 19. Here, the collection tank 16 is formed by the fences 3a and 3b, the collection tank 17 by the fences 3b and 3c, the collection tank 18 by the fences 3c and 3d, the collection tank 19 by the fences 3d and a partition plate 3e, respectively. Each of the fences 3a to 3d includes a cleaning mechanism, not shown, for cleaning its inside with pure water or the like and is made of a material excellent in chemical resistance and water absorption resistance, for example, Teflon (R).

Next, the lifting mechanism 28 will be described in detail.

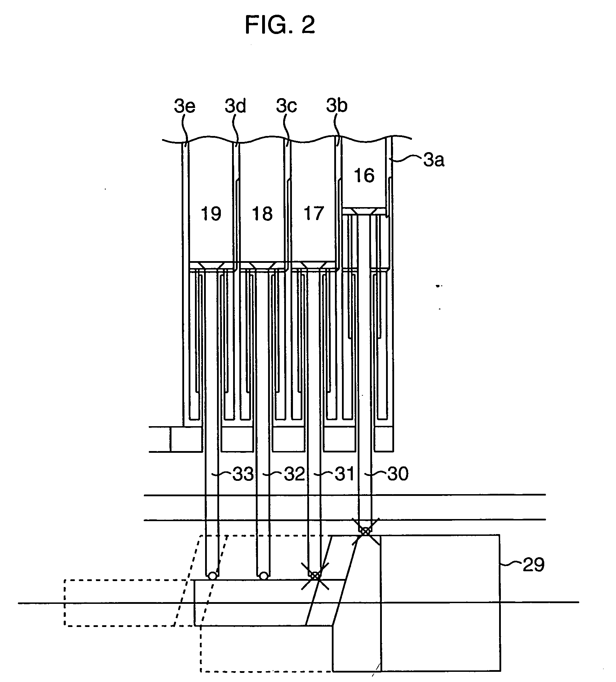

Fig. 2 is a schematic cross-sectional view of the lifting mechanism 28 in the substrate treatment apparatus of the present embodiment. As shown in Fig. 2, the lifting mechanism 28 has a cam 29 and shafts 30 to 33 for driving upwards the fences 3a to 3d that form the collection tanks 16 to 19.

In the substrate treatment apparatus of the present embodiment, the cam 29 can be rotated to drive the fences 3a to 3d upwards in order, from the outer fence 3a to 3d, via the shafts 30 to 33. The lifting mechanism 28 is driven to drive the corresponding fences 3a to 3d forming each of collection tanks for each chemical supplied from the chemical nozzle 12, so that the collection can be performed with inlets of the other collection tanks closed.

Subsequently, the installation states of the fences 3a to 3d forming the collection tanks 16 to 19 will be described.

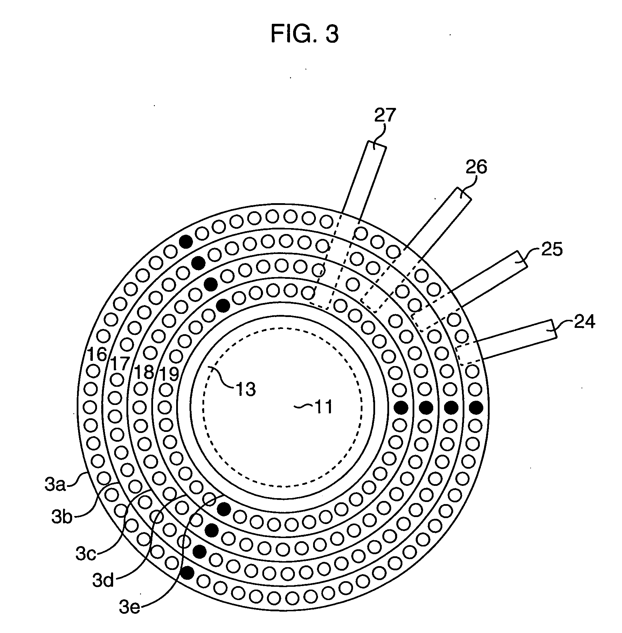

Fig. 3 is a cross-sectional view of the inside of the substrate treatment apparatus of the present embodiment as viewed from the above.

The present embodiment shows the case as having four collection tanks. The collection tanks 16 to 19 are formed partitioned by the circular fences 3a to 3d in a manner to surround the periphery of the substrate 11, and the respective shafts 30 to 33 are located at three places (portions indicated by ●) on the bottom surface for the collection tanks 16 to 19 respectively. Further, at portions indicated by ○ shown in Fig. 3, drain ports are provided and configured to allow the collected chemicals to be drained from the drain ports. Besides, numerals 24 to 27 shown in Fig. 3 denote exhaust mechanisms provided at the respective collection tanks 16 to 19 for exhausting collected gasses.

Subsequently, inlet portions of the collection tanks 16 to 19 will be described in detail.

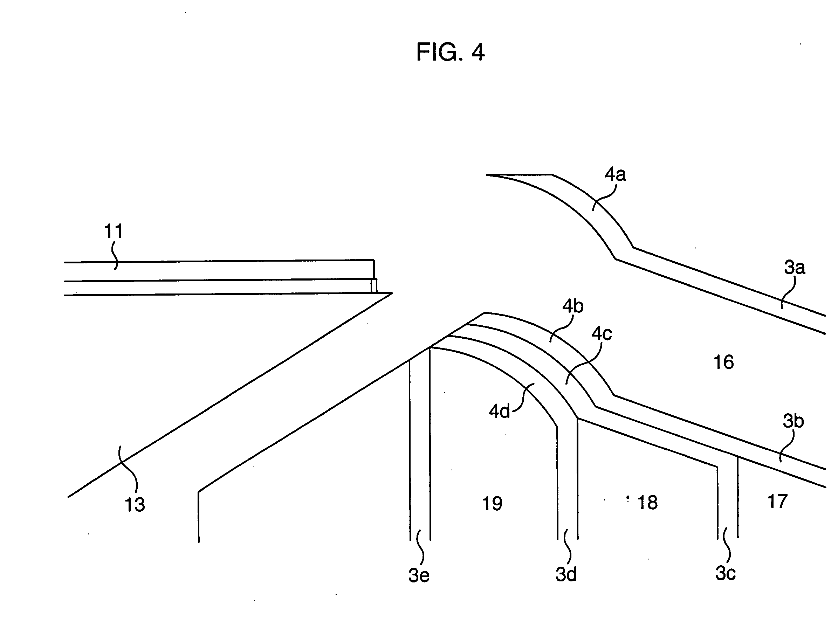

Fig. 4 is a schematic cross-sectional view showing tip portions of the fences forming the collection tanks 16 to 19.

Fig. 4 is a cross-sectional view showing the state in which the chemical, which has been supplied from a chemical supply unit onto the substrate 11 and treated the substrate 11, is collected by the collection tank 16. Only the inlet of the collection tank 16 is opened and all of the inlets of the other collection tanks 17 to 19 are closed.

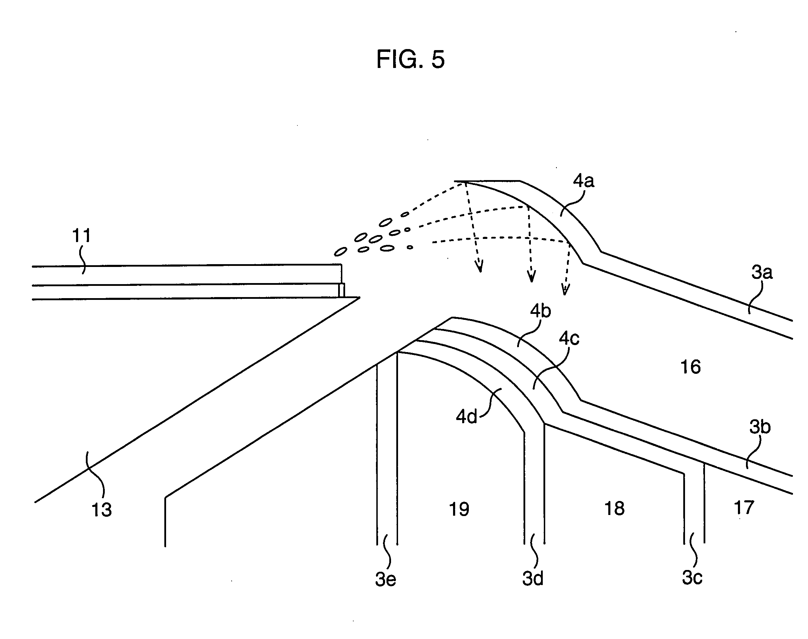

As shown in Fig. 4, tip portions 4a to 4d of the fences 3a to 3d have curved structures so that the collection tanks 16 to 19 can be brought into closed states by just overlapping the tip portions 4a to 4d one another. Further, the tip portions 4a to 4d are shaped such that even if chemicals strike them, the chemicals never attach thereto and settle there, and that the chemicals are reflected to the outside of the collection tanks 16 to 19. Further, the tip portions 4a to 4d are shaped such that if, for example, the chemical striking the tip portion 4a falls onto a tip part of the curved tip portion 4b of the fence 3b located under the tip portion 4a, the chemical flows down to the outside of the collection tank 16 via the tip portions 4b to 4d. Moreover, the tip portions 4a to 4d do not need to be sealed with packing or the like, but the fences 3a to 3d are overlapped one another to cause negative pressure in the collection tanks and bring them into closed states. Accordingly, when a chemical is being collected by the other collection tank, the chemical never mixes into the collection tanks in the closed states. In this case, as shown in Fig. 5, the tip portions 4a to 4d have a curvature set such that even if the chemical scattering from the surface of the substrate 11 strikes the tip portions 4a to 4d, the tip portion 4a in the example shown in the drawing, the chemical is reflected to the inside of the collection tanks 16 to 19, the collection tank 16 in the example shown in the drawing, so as not to scatter to the outside of the collection tank 16, whereby the chemical can be reliably collected only into the collection tank corresponding to the chemical.

Next, the procedure of collecting the chemical which has treated the substrate in the substrate treatment apparatus of the present embodiment will be described.

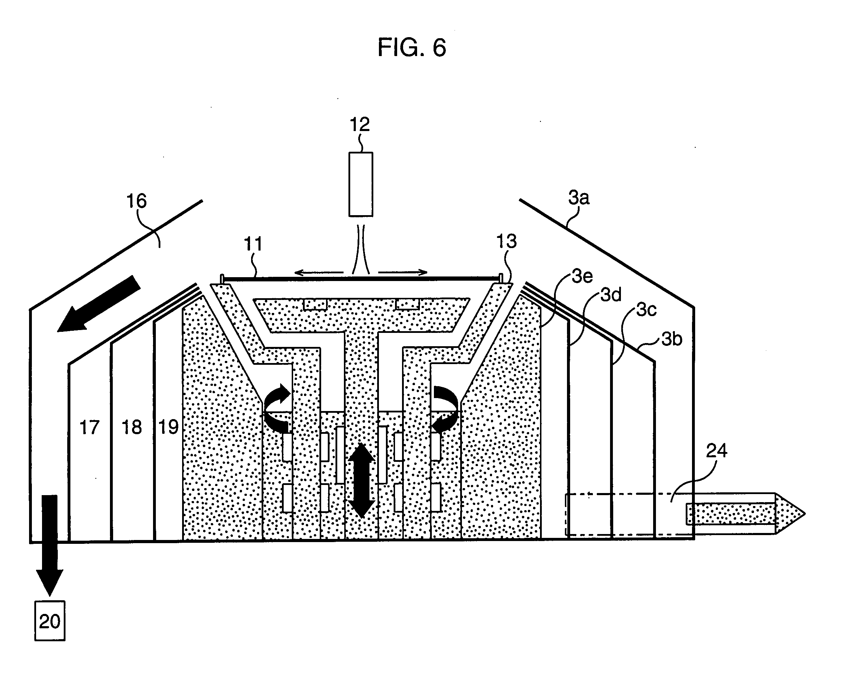

Fig. 6 to Fig. 9 are schematic cross-sectional views showing the procedure of the chemical collection of the substrate treatment apparatus of the present embodiment.

Although an example in which four kinds of chemicals are collected by the four collection tanks 16 to 19 formed by the fences 3a to 3d and a partition plate 3e which are placed in a manner to surround the periphery of the substrate 11 will be described in the present embodiment, the present invention is not limited to this, but it is also possible to configure, for example, five or more collection tanks by further increasing the fences in number.

As shown in Fig. 6, prior to supply of a first chemical from the chemical nozzle 12, the lifting mechanism 28 drives upwards the fence 3a of the collection tank 16 to open its inlet. In this event, the inlets of the other collection tanks 17 to 19 are closed.

In this state, the first chemical is supplied from the chemical nozzle 12 while the substrate 11 held on the substrate chuck section 13 is being spun by the motor 15 to thereby treat the substrate 11. The first chemical which has treated the substrate 11 is scattered from the substrate 11 due to the spin of the motor 15 and is collected in the collection tank 16. In this event, the chemical scattered from the substrate by centrifugal force of the spin mixes with ambient air and is collected in the collection tank 16 in a mist form or a gas form. The chemical collected in the collection tank 16 is drained from the drain mechanism 20 and the collected gas is exhausted from the exhaust mechanism 24.

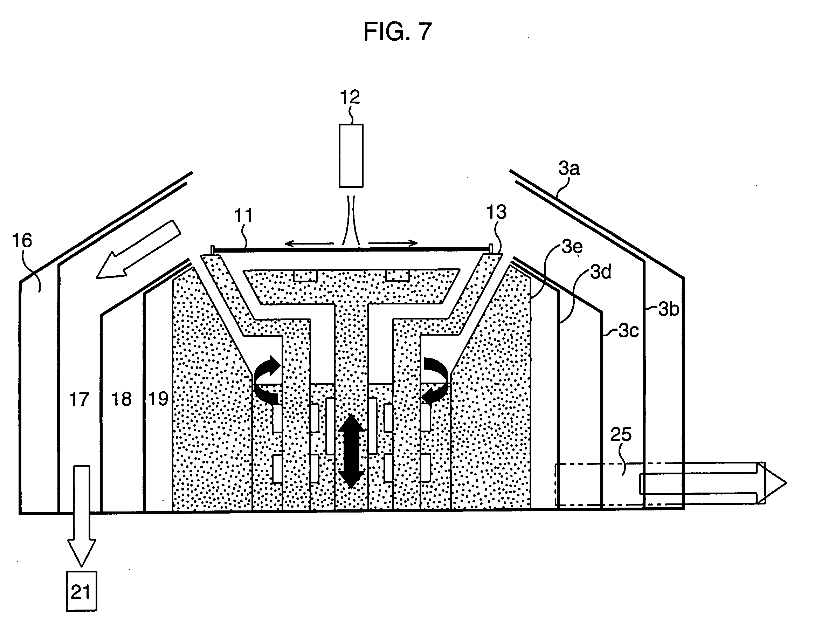

Subsequently, as shown in Fig. 7, prior to supply of a second chemical from the chemical nozzle 12, the lifting mechanism 28 drives upwards the fence 3b of the collection tank 17 to a position to open the inlet of the collection tank 17 and close the inlet of the collection tank 16. In this event, the inlets of the collection tanks 18 and 19 are closed, bringing about a state in which only the inlet of the collection tank 17 is opened.

In this state, the second chemical is supplied from the chemical nozzle 12 while the substrate 11 is being spun by the motor 15 to thereby treat the substrate 11. The second chemical which has treated the substrate 11 is scattered from the substrate 11 due to the spin of the motor 15 and is collected in the collection tank 17. In this event, the chemical scattered from the substrate by centrifugal force of the spin mixes with ambient air and is collected in the collection tank 17 in a mist form or a gas form. The chemical collected in the collection tank 17 is drained from the drain mechanism 21 and the collected gas is exhausted from the exhaust mechanism 25.

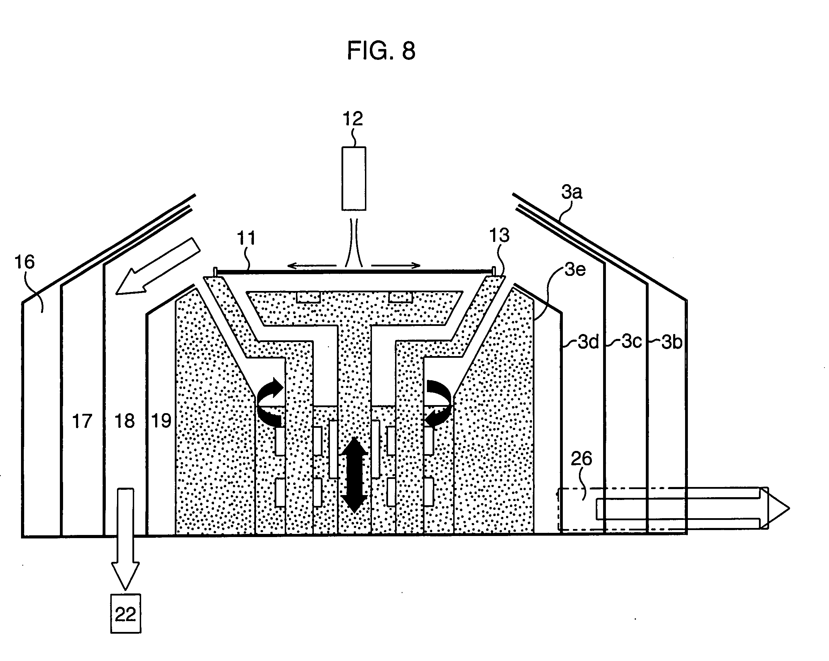

Subsequently, as shown in Fig. 8, prior to supply of a third chemical from the chemical nozzle 12, the lifting mechanism 28 drives upwards the fence 3c of the collection tank 18 to a position to open the inlet of the collection tank 18 and close the inlet of the collection tank 17. In this event, the inlets of the collection tanks 16 and 19 are closed, bringing about a state in which only the inlet of the collection tank 18 is opened.

In this state, the third chemical is supplied from the chemical nozzle 12 while the substrate 11 is being spun by the motor 15 to thereby treat the substrate 11. The third chemical which has treated the substrate 11 is scattered from the substrate 11 due to the spin of the motor 15 and is collected in the collection tank 18. In this event, the chemical scattered from the substrate by centrifugal force of the spin mixes with ambient air and is collected in the collection tank 18 in a mist form or a gas form. The chemical collected in the collection tank 18 is drained from the drain mechanism 22 and the collected gas is exhausted from the exhaust mechanism 26.

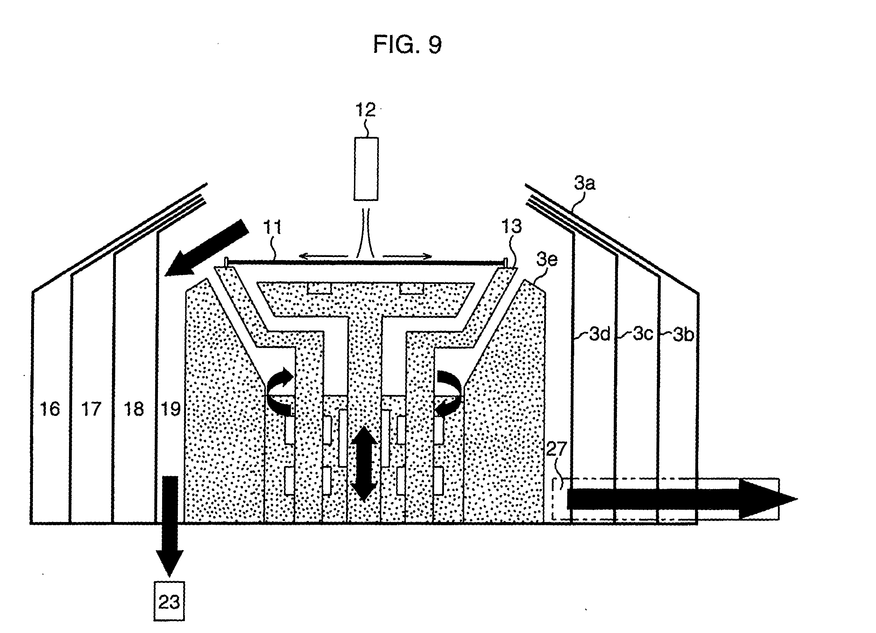

Subsequently, as shown in Fig. 9, prior to supply of a fourth chemical from the chemical nozzle 12, the lifting mechanism 28 drives upwards the fence 3d of the collection tank 19 to a position to open the inlet of the collection tank 19 and close the inlet of the collection tank 18. In this event, the inlets of the collection tanks 16 and 17 are closed, bringing about a state in which only the inlet of the collection tank 19 is opened.

In this state, the fourth chemical is supplied from the chemical nozzle 12 while the substrate 11 is being spun by the motor 15 to thereby treat the substrate 11. The fourth chemical which has treated the substrate 11 is scattered from the substrate 11 due to the spin of the motor 15 and is collected in the collection tank 19. In this event, the chemical scattered from the substrate by centrifugal force of the spin mixes with ambient air and is collected in the collection tank 19 in a mist form or a gas form. The chemical collected in the collection tank 19 is drained from the drain mechanism 23 and the collected gas is exhausted from the exhaust mechanism 27.

The treatment as described above is performed, whereby when a plurality of kinds of chemicals are collected in respective predetermined collection tanks, the chemicals can be collected without mixing into different collection tank, leading to efficient separate collection and separate discard. It is also possible to configure the position of the substrate 11 held on the substrate chuck section 13 to be above the positions of the fences 3a to 3d when not collecting the treatment solutions, so as to smoothly carry in/out the substrate 11.

According to the present embodiment, it becomes possible to ensure that when various different treatment solutions are used to perform various treatments on the substrate and then collected, mixing of the used treatment solutions is prevented, thus enabling reliable substrate treatment.

### Industrial Applicability

According to the present invention, collection of a treatment solution which has treated a substrate, when collected by a collection tank, is performed with inlets of other collection tanks closed, thus making it possible to prevent the treatment solution to be collected from mixing into the other collection tanks. Therefore, for example, when performing a treatment using an acid chemical and a treatment using an alkaline chemical, substrate treatments can be carried out in successive process steps in the same apparatus configuration without occurrence of salt produced by the mixing of them which causes particles.

Further, according to another feature of the present invention, a substrate to be treated held on a substrate holding unit is placed at a position above the positions of the fences forming the collection tanks when not collecting treatment solutions, so that the substrate to be treated can be smoothly carried in/out.

Furthermore, according still another feature of the present invention, the tip portions of the fences forming the collection tanks are configured to be curved, so that a treatment solution scattered from the substrate to be treated, even when striking the tip portion of the fence, can be prevented from scattering to the outside of the collection tank, resulting in efficient collection of the treatment solution.

## Claims

1. A substrate treatment apparatus, comprising:
a substrate holding unit holding a substrate to be treated;
a substrate spinning unit spinning the substrate to be treated held on said substrate holding unit;
a treatment solution supply unit supplying a plurality of treatment solutions onto the substrate to be treated; and
a treatment solution collection unit having a plurality of collection tanks placed in a manner to surround a periphery of the substrate to be treated held on said substrate holding unit, and provided to separately collect by kind the treatment solutions scattered by said substrate spinning unit from the substrate to be treated,
wherein said treatment solution collection unit collects the treatment solution by one of the collection tanks with inlets of the other collection tanks closed.

2. The substrate treatment apparatus according to claim 1, wherein said treatment solution collection unit has a plurality of fences and drives upwards a predetermined fence to thereby form a conduit of said collection tank which collects the treatment solution.

3. The substrate treatment apparatus according to claim 2, wherein a position of the substrate to be treated held on said substrate holding unit is located above positions of the fences which are not collecting the treatment solution.

4. The substrate treatment apparatus according to claim 2, wherein:
the fences are arranged overlapping one another in order, from the fence closer to the substrate to be treated, in a manner to close the inlets of the collection tanks; and
said treatment solution collection unit performs collection in order, starting from the collection tank at a position farther from the substrate to be treated.

5. The substrate treatment apparatus according to claim 2, wherein the fence has a tip portion formed to be a reflective face that is curved to reflect the treatment solution scattered from the substrate to be treated to lead the treatment solution into the collection tank selected.

6. The substrate treatment apparatus according to claim 1, wherein exhaust units separately exhausting internal gasses are provided for the collection tanks, respectively.

7. The substrate treatment apparatus according to claim 1, wherein drain units draining the treatment solutions are provided for the collection tanks, respectively.

8. The substrate treatment apparatus according to claim 1, further comprising a cleaning unit cleaning the inside of said collection tanks.

9. A substrate treatment method, comprising the steps of:
supplying a plurality of treatment solutions onto a held substrate to be treated while spinning the substrate; and
when using a treatment solution collection unit having a plurality of collection tanks placed in a manner to surround a periphery of the substrate to be treated and provided to separately collect by kind the treatment solutions scattered from the substrate to be treated, to collect the treatment solution by one of the collection tanks, collecting the treatment solution only by the one of the collection tanks with inlets of the other tanks closed.

10. The substrate treatment method according claim 9, wherein the treatment solution collection unit has a plurality of fences and drives upwards a predetermined fence to thereby form a conduit of the collection tank which collects the treatment solution.

11. The substrate treatment method according claim 10, wherein a position of the held substrate to be treated is located above positions of the fences which are not collecting the treatment solution.

12. The substrate treatment method according claim 10, wherein:
the fences are arranged overlapping one another in order, from the fence closer to the substrate to be treated, in a manner to close the inlets of the collection tanks; and
said step of collecting the treatment solution performs collection in order, starting from the collection tank at a position farther from the substrate to be treated.

13. The substrate treatment method according claim 10, wherein the fence has a tip portion formed to be a reflective face that is curved to reflect the treatment solution scattered from the substrate to be treated to lead the treatment solution into the collection tank selected.

14. The substrate treatment method according claim 9, further comprising an exhausting step of separately exhausting internal gasses for the collection tanks, respectively.

15. The substrate treatment method according claim 9, further comprising a drain step of draining the treatment solutions for the collection tanks, respectively.

16. The substrate treatment method according claim 9, further comprising a cleaning step of cleaning the inside of the collection tanks.
